# EUROPEAN PATENT SPECIFICATION

(11) **EP 0 415 775 B1**
(45) Date of publication and mention of the grant of the patent: **15.03.1995**
(21) Application number: 90309526.3
(22) Date of filing: 30.08.1990
(51) Int. Cl.: H01L 29/788, H01L 21/28, G11C 17/00

(54) **Method of manufacturing a semiconductor memory device**
Verfahren zur Herstellung einer Halbleiterspeicheranordnung
Méthode de fabrication d'un dispositif semi-conducteur de mémoire

(30) Priority: 31.08.1989 JP 225303/89
(43) Date of publication of application: 06.03.1991
(73) Proprietor: KABUSHIKI KAISHA TOSHIBA, Kawasaki-shi, Kanagawa-ken 210 (JP)
(72) Inventor: Tsunoda, Hiroaki, 1-1-1, Shibaura, Minato-ku, Tokyo (JP)
(74) Representative: Freed, Arthur Woolf

(56) References cited:
- EP-A- 0 228 206
- PATENT ABSTRACTS OF JAPAN, vol. 8, no. 173 (E-259)[1610], 9th August 1984;& JP-A-59 066 171
- IDEM
- PATENT ABSTRACTS OF JAPAN, vol. 10, no. 259 (E-434)[2315], 4th September 1986;& JP-A-61 084 868
- PATENT ABSTRACTS OF JAPAN, vol. 10, no. 343 (E-456)[2399], 19th November 1986;& JP-A-61 147 576

## Description

This invention relates to a method for manufacturing a non-volatile memory, example for an EEPROM, into which data can be electrically written and in which data can be electrically erased. A known device of the aforementioned kind is disclosed in Japanese patent specifications JP-A-59066171 and JP-A-61147576. The latter document also discloses a method of manufacturing such a device.

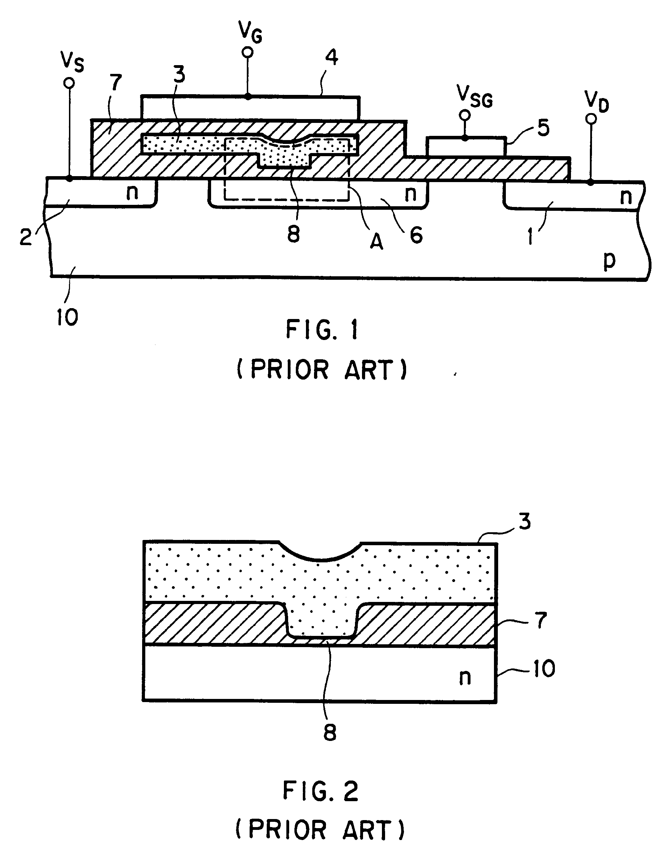

An EEPROM generally has an element structure as shown in cross-sectional view in Figure 1. A drain region 1 and a source region 2 of an N-type impurity region are formed in a P-type silicon substrate 10. An N-type impurity region 6 is formed between each region 1, 2. A control gate 4 is layered above the N-type impurity region 6 through a silicon oxide layer 7. Also, a floating gate 3 of a polysilicon layer is formed in the silicon oxide layer 7. This silicon oxide layer SiO₂ (silicon dioxide) 7 includes a part of a tunnel insulation layer 8 thinner than the thickness of layer 7. Electrons formed in the N-type impurity region 6 are thus injected into the floating gate 3 where the electrons are accumulated and are drawn therefrom by the tunnel effect. Further a selecting gate 5 is layered on the silicon oxide layer 7 between the N-type impurity region 6 and drain region 1.

Figure 2 shows a partial expanded structure of the EEPROM structure shown in Figure 1. This is enclosed by a dotted line A and includes the part of the tunnel insulation layer 8 and the part of the floating gate 3. The structure shown in Figure 2 is formed by a method explained below.

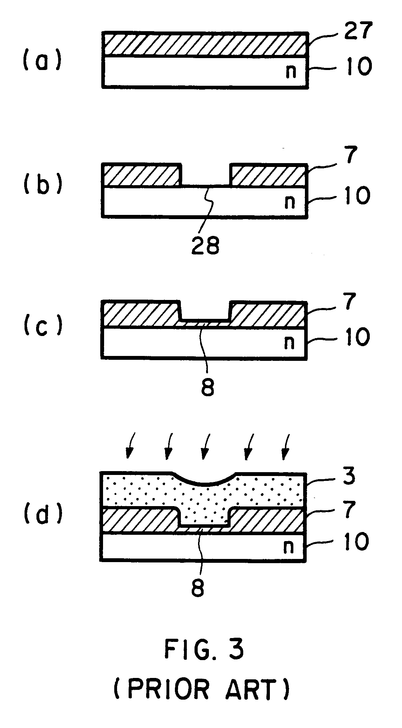

As shown in Figure 3(a), a silicon oxide layer 27 is layered on the entire surface of the silicon substrate 10 having the N-type impurity 6. Part of the silicon oxide layer 27 is removed by a photolithographic process in order to form the tunnel insulation layer 8. A surface 28 of part of the silicon substrate 10 is exposed (Figure 3(b)). Further, the tunnel insulation 8 is formed on the surface of the exposed substrate (Figure 3(c)), and the polysilicon layer 3 is layered on the silicon layer 7, 8. Phosphorus impurity is diffused in the polysilicon layer 3 by being placed in an atmosphere of POCl₃, in order to improve the conductivity of the polysilicon 3 (Fig. 3(d)).

However, this semiconductor memory device has the following drawbacks.

As shown in Figure 3(b), when part of the silicon oxide layer 27 is removed by photolithography and a region is exposed in order to form the tunnel insulation layer 8, after the silicon oxide layer 27 is layered on the entire surface of the silicon substrate 10, the surface 28 of the exposed substrate 10 is contaminated. That is because the photoresist is removed using a solution which includes H₂SO₄ and H₂O₂, with the surface exposed. As a result, the dielectric breakdown voltage of the tunnel insulation layer 8 is remarkably reduced. To prevent the above drawbacks, a process of dipping into a diluted HF solution is employed. Also, in the process step of Figure 3(d), phosphorus is diffused into the polysilicon layer 3. However, the pressure resistance of this part of the tunnel insulation layer 13 is reduced because this phosphorus also diffuses into the part of the insulation layer 8.

For investigating the TDDB (Time Dependent Dielectric Breakdown) of the tunnel insulation layer 8, a method is used which involves application of a constant current to the part of the tunnel insulation layer 8. By this method, the product defect rate over a predetermined period is investigated. For examining the dielectric breakdown voltage of the silicon oxide layer 7, a method is used which involves applying a voltage between the selecting gate 5 and the silicon substrate 10 until the part of the silicon oxide layer 7 between them is destroyed. By this method, the product defect rate at an applied voltage of 20 V or less can be determined. However, it is not possible to get good results using these two methods because of the aforementioned drawbacks.

Accordingly, it is an object of this invention to propose a novel method of manufacturing a semiconductor device which is able to improve the dielectric breakdown voltage of tunnel insulation layer and a gate oxide layer under a selecting gate.

According to the invention, there is provided a method of manufacturing a non-volatile semiconductor memory device comprising a floating gate formed on an insulating layer, the method comprising the steps of:
forming a first insulation layer on a semiconductor substrate;
forming a second insulation layer on the first insulation layer;
removing only the second insulation layer except a tunnel insulation part where electrons formed in the substrate are able to pass through;
forming a third insulation layer by means of oxidizing the exposed first insulation layer;
forming a polysilicon layer on the third and second insulation layers the polysilicon layer constituting said floating gate, and the first, second and third insulating layers constituting said insulating layer.

By virtue of this process, the dielectric breakdown voltage of the tunnel insulation layer is increased because the surface of the substrate of the tunnel region is not exposed. Furthermore, it is not necessary to use the photolithographic process to remove the silicon oxide layer of the part of the tunnel when forming the second insulation layer, after the step of forming the first insulation layer. Still further, the dielectric breakdown voltage of the tunnel insulation layer is improved because the resultant device has the second insulation layer, which prevents the impurity of the polysilicon sinking into the part of the tunnel insulation layer.

One known method for manufacturing a memory device is disclosed in Japanese patent specification JP-A-61147576.

These and other objects of the invention will be apparent from the following description and accompanying drawings, which are given by way of example only.
Figure 1 is a cross-sectional view of a portion of a known semiconductor memory device;
Figure 2 is a magnified illustration of a part A shown in Figure 1;
Figures 3 (a) to (d) are sectional views of a process of manufacturing the device shown in Figure 2;
Figures 4 (a) to (d) are sectional views of a process of manufacturing a semiconductor memory device comprising the basic steps know from JP-A-61-147576;
Figure 5 illustrates a semiconductor memory device completed by using the process of Fig.4;
Figures 6 (a) to (d) are sectional views of an embodiment of a process of manufacturing a semiconductor memory device in accordance with this invention;
Figures 7 (a) to (d) are sectional views of a further process of manufacturing a semiconductor memory device similar to the process of Fig.4; and
Figures 8 (a) to (c) are sectional views of yet another process of manufacturing a semiconductor similar to the process of Fig.4.

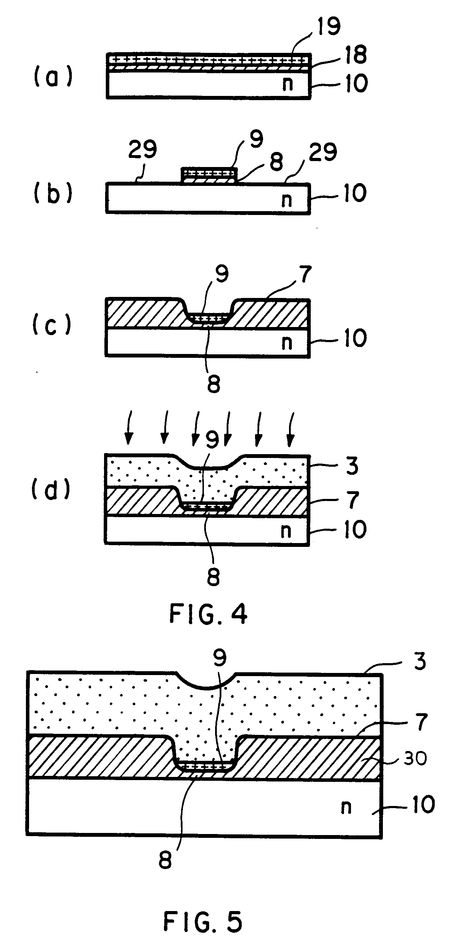

An embodiment of the present invention is described below with reference to the drawings. Figure 4 shows cross-sectional views for explaining the process steps in carrying out a method essentially known from JP-A-61147576. In the prior art process of Figure 3, the tunnel oxide layer 8 is thinner than if it is formed after layering the thick silicon oxide layer 27. However, in the process of Fig.4, the order of the steps in the manufacturing process is reversed.

As shown in Figure 4(a), a silicon oxide layer 18 having the same thickness (90 Angstroms) as a tunnel oxide layer 8 is layered on a surface where an N-type impurity region is formed in a P-type silicon substrate 10, by being placed in an atmosphere of 0₂ including HCl at about 800°C. A second insulation layer of Si₃N₄ denoted by reference numeral 19 is layered on the silicon oxide layer 18 by chemical vapor deposition (CVD). The silicon oxide layer 18 and Si₃N₄ layer 19 are removed by a photolithographic process, except for a tunnel part 9, 8. Accordingly a surface 29 of the substrate 10, except a tunnel region of SiO₂ (silicon dioxide) 8 and a tunnel region of Si₃N₄ (silicon nitride layer) 9, is exposed (Figure 4(b)).

The next process step involves fabrication of an insulation layer 7, which is 430 Angstroms thick, on the surface 29. This insulation layer 7 is fabricated (except on the tunnel region 9, 8) by being placed in an atmosphere of O₂ including HC1 at about 900°C (Figure 4(c)).

A floating gate consisting of a polysilicon layer 3 of 4000 Angstroms thickness is then layered on top by chemical vapor deposition (CVD). This structure is placed in an atmosphere of POCl₃ at 900°C to diffuse phosphorus in the polysilicon layer 3 (Figure 4(d). The diffusion of phosphorus improves the conductivity of this layer.

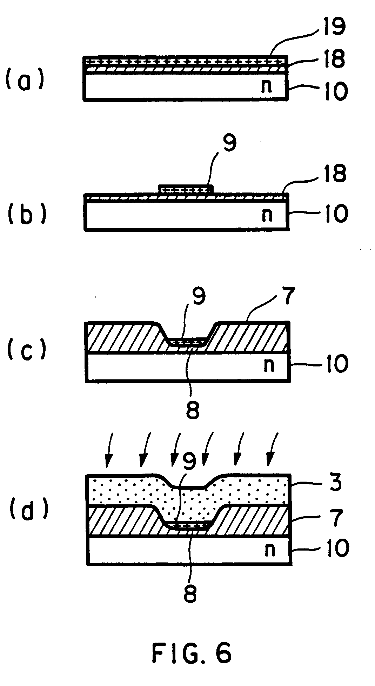

As a result, the semiconductor memory device (Figure 5) fabricated by the above process has a layer which is the tunnel Si₃N₄ layer 9. This is formed in order to prevent phosphorus which has diffused into the polysilicon layer 3 from diffusing into the tunnel insulation layer 8, which cannot be prevented in the particular prior art method of manufacture of semiconductor memory devices as shown in Figure 2.

Figure 6 shows an embodiment of a method according to the present invention. As shown in Figure 6(a), a silicon oxide layer 18 having the same thickness (90 Angstroms) as the tunnel oxide layer 8 is layered on a surface where an N-type impurity region is formed in a P-type silicon substrate 10. This is achieved by being placed in the atmosphere of O₂ including HCl at about 800°C, to form the silicon oxide layer 18 as a second insulation layer. Then Si₃N₄ layer 19 is layered on the silicon oxide layer 18 by CVD. In Figure 4(b), as with the preceding embodiment, both the silicon oxide layer 18 and the Si₃N₄ layer 19 are removed, except for the tunnel regions 9, 8. However, in this embodiment only the Si₃N₄ layer 19 is removed, except the tunnel region 9, by using photolithography. In other words, the silicon oxide layer 18 is exposed, except for the Si₃N₄ tunnel region layer 9.

Next, the same process steps as shown in Figure 4(c) and Figure 4(d) are carried out. Namely, the insulation layer 7 of 430 Angstroms thickness is fabricated on the silicon oxide layer 18, except that part of the silicon oxide layer 8 corresponding to the tunnel region by being placed in an atmosphere of O₂ including HCl, at about 900°C (Figure 6(c)). The polysilicon layer 3 of 4000 Angstroms thickness is layered on the tunnel Si₃N₄ layer 9 and the insulation layer 7 by CVD. Phosphorus is then diffused into the polysilicon layer 3 (Figure 6(d)).

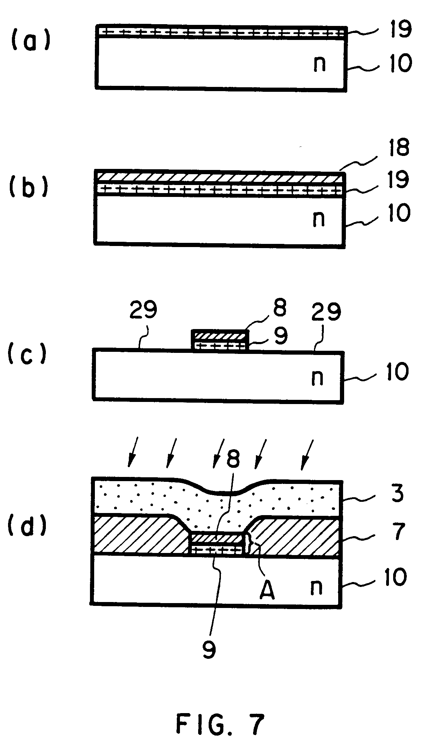

Figure 7 shows another method similar to the method of Fig.4. As shown in Figure 7(a), Si₃N₄ layer 19 having a 70 Angstroms thickness is layered on the semiconductor substrate 10 by being placed in an atmosphere of NH₄ at about 1000°C, i.e. by CVD.

Second, as shown in Figure 7(b), the silicon oxide layer 18 having 20 Angstroms thickness is layered on the Si₃N₄ 19 by being placed in the atmosphere of O₂ including HCl, at about 900°C.

Third, as shown in Figure 7(c), the Si₃N₄ layer 19 and silicon oxide layer 18 are removed except in the tunnel insulation region 8, 9, using the photolithographic process. Finally, as shown in Figure 7(d), the insulation layer 7 having 430 Angstroms thickness is formed on the exposed semiconductor substrate 29 by being placed in an atmosphere of O₂, including HCl at about 900°C. The silicon oxide layer 8 is not now oxidized because it has already been oxidized. Polysilicon layer 3 constituting a floating gate and having 4000 Angstroms thickness, is layered on the insulation layer 7 and the silicon oxide layer 8 by conventional CVD.

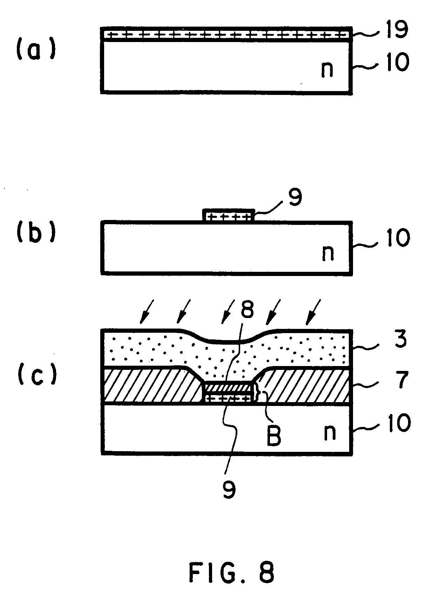

Figure 8 shows yet another method similar to that of Fig.4. A shown in Figure 8(a), Si₃N₄ layer 19 having 70 Angstroms is layered on the semiconductor substrate 10 by being placed in an atmosphere of NH₄ at about 1000°C, i.e. by CVD.

Second, as shown in Figure 8(b), the Si₃N₄ layer 19 is removed except for the tunnel insulation region 9 by photolithography. Third, as shown in Figure 8(c), the insulation layer 7 having 430 Angstroms thickness is formed on the exposed semiconductor substrate 29 and the remainder of Si₃N₄ layer 9 by being placed in an atmosphere of O₂, including HCl at about 900°C. Then, the remainder of Si₃N₄ layer 9 is slightly oxidized (numeral 8 shows this SiO₂ layer). Polysilicon layer 3 as floating gate, having 4000 Angstroms thickness, is layered on the insulation layer 7 and the thin SiO₂ layer 8 by conventional CVD. Finally, phosphorus is diffused into the polysilicon layer 3.

The above methods including the method of this invention give the following effects. In the particular prior art process step of Figure 3(b), the dilute HF (hydro-fluoric acid) process is carried out to prevent the surface 28 of the substrate 10 being polluted. As a result, the insulation layer 7 becomes polluted, and the dielectric breakdown voltage of the insulation layer 7 between the select gate 5 and the silicon substrate 10 is reduced. The above problem is solved by the above methods because the surface is not exposed as the tunnel oxide layer 8 or the tunnel Si₃N₄ is formed in advance. Therefore, the dielectric breakdown voltage of the insulation layer 7 is improved because the surface 28 does not become polluted and naturally, use of diluted HF is made unnecessary. Further, the Si₃N₄ layer 9 formed on the tunnel oxide layer 8 (shown in Figure 5) prevents diffusion of phosphorus from the polysilicon layer 3. Therefore, the dielectric breakdown voltage of the insulation layer 7 is increased

Accordingly, an EEPROM formed by the above methods including the method of this invention improves considerably both the tunnel oxide layer 8 and the silicon oxide layer 7.

As described above, the surface of the semiconductor where the part of the tunnel region is formed, is not exposed and not polluted because the silicon oxide layer is formed after the silicon oxide layer or the tunnel Si₃N₄ layer is formed (on the surface where the tunnel region is formed). As a result, the dielectric breakdown voltage of the tunnel oxide layer is improved. The silicon oxide layer, except the tunnel oxide layer, is prevented from being contaminated by being placed in an atmosphere diluted HF solution during the HF treatment. Moreover, the phosphorus diffused into the insulation layer 7 cannot sink into the tunnel insulation layer because the tunnel Si₃N₄ layer is formed. Therefore, the dielectric breakdown voltage of the tunnel oxide layer is increased.

In order to block impurities diffused into the polysilicon layer 3 from reaching the tunnel insulation layer or surface of substrate where the tunnel insulation part is formed, the insulation layer 9 is formed of a material which is difficult to oxidize and has a higher dielectric constant, example for Al₂O₃ (aluminium oxide) and TiO₂ (titanium oxide).

The invention is not limited to the specific details and illustrated examples shown and described herein. Additional modifications will readily occur to those skilled in the art, without departing from the scope of the present invention as defined by the appended claims.

## Claims

1. A method of manufacturing a non-volatile semiconductor memory device comprising a floating gate formed on an insulator layer, the method comprising the steps of:
forming a first insulation layer (18) on a semiconductor substrate (10);
forming a second insulation layer (19) on the first insulation layer;
removing only the second insulation layer except a tunnel insulation part (9) where electrons formed in the substrate are able to pass through;
forming a third insulation layer (7) by means of oxidizing the exposed first insulation layer;
forming a polysilicon layer (3) on the third and second insulation layers (7, 19) the polysilicon layer constituting said floating gate, and the first, second and third insulating layers constituting said insulating layer.

2. A method of manufacturing a non-volatile semiconductor memory device according to claim 1, further comprising the step of:
diffusing an impurity into the polysilicon layer (3) for improving the conductivity thereof.

## Patentansprüche

1. Verfahren zur Herstellung einer nichtflüchtigen Halbleiterspeicheranordnung mit einem auf einer Isolierschicht ausgebildeten floatenden Gate, wobei das Verfahren die folgenden Schritte aufweist:
Ausbilden einer ersten Isolierschicht (18) auf einem Halbleitersubstrat (10);
Ausbilden einer zweiten Isolierschicht (19) auf der ersten Isolierschicht;
Entfernen nur der zweiten Isolierschicht bis auf einen Tunnelisolierteil (9) wo im Substrat gebildete Elektronen durchgelassen werden;
Ausbilden einer dritten Isolierschicht (7) durch Oxidieren der freiliegenden ersten Isolierschicht;
Ausbilden einer Polysiliziumschicht (3) auf der dritten und der zweiten Isolierschicht (7, 19),
wobei die Polysiliziumschicht das floatende Gate bildet und die erste, zweite und dritte Isolierschicht die genannte Isolierschicht bilden.

2. Verfahren zur Herstellung einer Halbleiterspeicheranordnung nach Anspruch 1, das ferner den folgenden Schritt aufweist:
Diffusion von Störatomen in die Polysiliziumschicht (3) zur Verbesserung ihrer Leitfähigkeit.

## Revendications

1. Procédé de production d'un dispositif de mémoire rémanente à semiconducteur comportant une grille flottante formée sur une couche isolante, comprenant les étapes ci-dessous:
formation d'une première couche isolante (18) sur un substrat semiconducteur (10);
formation d'une deuxième couche isolante (19) sur la première couche isolante;
élimination de la seule deuxième couche isolante, à l'exception d'une partie isolante à effet tunnel (9) que peuvent traverser les électrons formés dans le substrat;
formation d'une troisième couche isolante (7) par oxydation de la première couche isolante exposée;
formation d'une couche de polysilicium (3) sur les troisième et deuxième couches isolantes (7, 19), la couche de polysilicium constituant ladite grille flottante et les première, deuxième et troisième couches isolantes constituant ladite couche isolante.

2. Dispositif de mémoire à semi-conducteur selon la revendication 1, comprenant en outre l'étape suivante:
diffusion d'une impureté dans la couche de polysilicium (3) pour améliorer la conductivité de celle-ci.
